(19) **Europäisches Patentamt**

**European Patent Office**

**Office européen des brevets**

(11) **EP 0 874 244 B1**

(12) **EUROPÄISCHE PATENTSCHRIFT**

(45) Veröffentlichungstag und Bekanntmachung des Hinweises auf die Patenterteilung:
**30.01.2002 Patentblatt 2002/05**

(51) Int Cl.$^7$: **G01R 15/20**

(21) Anmeldenummer: **98105070.1**

(22) Anmeldetag: **20.03.1998**

(54) **Verfahren zum Messen von elektrischen Strömen in n Leitern sowie Vorrichtung zur Durchführung des Verfahrens**

Procedure and apparatus for measuring electric currents in conductors

Procédé et appareil pour mesurer des courants électriques dans des conducteurs

(84) Benannte Vertragsstaaten:
**DE FR GB**

(30) Priorität: **19.04.1997 DE 19716518**
 **03.11.1997 DE 19748550**

(43) Veröffentlichungstag der Anmeldung:
**28.10.1998 Patentblatt 1998/44**

(73) Patentinhaber: **Lust Antriebstechnik GmbH**
**35633 Lahnau (DE)**

(72) Erfinder:
• **Hebing, Ludger, Dipl.-Ing.**
 **35614 Asslar (DE)**
• **Kunze, Jürgen, Dipl.-Ing.**
 **35585 Wetzlar (DE)**
• **Kammer, Thomas, Dipl.-Ing.**
 **35444 Biebertal (DE)**
• **Bünte, Andreas, Dipl.-Ing.**
 **35452 Heuchelheim (DE)**
• **Weber, Jan Thorsten, M.E.S., Dipl.-Ing.**
 **35452 Heuchelheim (DE)**

(74) Vertreter: **Knefel, Cordula, Dipl.-Phys. et al**
**Patentanwälte Knefel & Knefel Postfach 19 24**
**35529 Wetzlar (DE)**

(56) Entgegenhaltungen:
**EP-A- 0 597 404    EP-A- 0 710 844**

• **KOLB E: "NEUES MESSVERFAHREN FUR ECHTZEITSTRONMSENSOREN UND DIE ANWENDUNG INDER PRUFTECHNIK" MESSEN PRUFEN AUTOMATISIEREN INTERNATIONALES FACHJOURNAL FUR MESS-, STEUER- UND REGELTECHNIK, Nr. 12, 1. Dezember 1989, Seite 600/611 XP000085050**
• **PATENT ABSTRACTS OF JAPAN vol. 8, no. 192 (P-298) [1629], 4. Juli 1984 & JP 59 079860 A (MITSUNORI MATSUMOTO), 9. Mai 1984**

## Beschreibung

Die Erfindung betrifft ein Verfahren zum Messen von elektrischen Strömen in n Leitern (n = natürliche Zahl und n ≥ 2) sowie eine Vorrichtung zur Durchführung des Verfahrens.

Gemäß dem Stand der Technik (DE-PS 43 00 605 C2) ist es bekannt, elektrische Ströme mit Hilfe eines magnetoresistiven Sensorchips zu messen, bei dem das Ausgangssignal einem auszumessenden elektrischen Strom proportional ist. Mit Hilfe des magnetoresistiven Sensorchips ist es möglich, eine potentialfreie Messung der Stromstärke eines elektrischen Stromes durchzuführen, indem das von dem elektrischen Strom verursachte Magnetfeld und die Magnetfeld-Gradienten mit dem Sensorchip gemessen werden.

Sollen gemäß dem Stand der Technik dreiphasige Ströme gemessen werden, werden Hall-Wandler eingesetzt. Der Nachteil der Hall-Wandler besteht darin, daß aufgrund der physikalisch vorgegebenen Magnetfeldempfindlichkeit der Hall-Elemente in jedem Fall ein Eisenkern (Blechpakete oder Ferrite) zur Flußführung und Feldkonzentration eingesetzt werden muß. Damit ergibt sich ein relativ großes Bauvolumen, welches für die Integration in planare Aufbautechniken, wie zum Beispiel Hybridschaltungen, ein großes Hindernis darstellt. Hinzu kommt, daß die Hall-Elemente in einen Luftspalt des Flußkonzentrators montiert werden müssen, was den Aufwand zur Einhaltung der Luft- und Kriechstrecken durch Vergußmaßnahmen erhöht, sofern der Meßleiter gegen den Eisenkern nicht ausreichend isoliert werden kann.

Gemäß der EP 597 404 A2 ist eine Anordnung bekannt, bei der mit weniger Sensoren gearbeitet wird, als Ströme zu ermitteln sind, das heißt, es werden zum Beispiel mit zwei Sensoren die Ströme eines Dreileitersystems erfaßt. Gemäß dieser Druckschrift wird nicht das einzelne Magnetfeld des elektrischen Leiters, sondern das Summenmagnetfeld, das in einem Mehrleitersystem durch Überlagerung der einzelnen Magnetfelder entsteht, zu Meßzwecken herangezogen (Seite 2, Zeilen 50 bis 52). Durch die vektorielle Erfassung der Feldstärken müssen die Winkel der Anordnung bekannt sein. Hierdurch wird eine komplizierte Rechnung erforderlich, welche aufwendig und unpraktisch ist.

Darüber hinaus sind gemäß der Druckschrift EP 597 404 A2 Sensoren notwendig, die ein der vektoriellen magnetischen Feldstärke proportionales elektrisches Meßsignal liefern.

Gemäß dieser Druckschrift ist es nicht möglich, n Ströme mit beliebigen Signalformen mit n-1 Sensoren zu bestimmen.

Weiterhin gehören zum Stand der Technik (EP 710 844 A2) Anordnungen von Magnetfeldgradiometern zur Bestimmung von Stromstärken, die sich jedoch ausschließlich zur Bestimmung von Wechselfeldern eignen. Gleichgrößen und nichtperiodische Stromverläufe lassen sich gemäß dieser Druckschrift nicht oder nur mit einem erhöhten Aufwand erfassen. Diese zum Stand der Technik gehörende Anordnung hat darüber hinaus den Nachteil, daß die Empfindlichkeit des verwendeten Sensorsystems von der Frequenz der Stromstärke abhängt. Mit dieser Anordnung ist die Messung von Strömen, die ein beliebiges Leistungsspektrum aufweisen, praktisch unmöglich.

Das der Erfindung zugrunde liegende technische Problem besteht darin, ein Verfahren zum Messen von elektrischen Strömen in wenigstens zwei Leitern anzugeben, welches einen technisch einfachen und einen kompakten Aufbau der Meßanordnung erlaubt, und bei dem durch eine einfache Rechnung die gewünschten Werte ermittelt werden können, und welches die Messung beliebiger zeitlicher Verläufe der Leiterströme erlaubt, wenn die Randbedingung ΣI = 0 eingehalten wird, sowie eine Vorrichtung zur Durchführung des Verfahrens, welche sich durch einen einfachen und kompakten Aufbau auszeichnet, und mit der externe Störfelder unterdrückt werden können.

Dieses technische Problem wird durch die Merkmale des Anspruches 1 sowie durch die Merkmale des Anspruches 12 gelöst.

Dadurch, daß gemäß der Erfindung magnetoresistive Sensoren verwendet werden, die als Gradiometer ausgebildet sind, das heißt, die die Differenz der von den Leiterströmen erzeugten magnetischen Feldstärken erfassen, erhält man gemäß dem erfindungsgemäßen Verfahren bei n Leitern n-1 skalare Größen. Erfindungsgemäß erhält man durch eine einfache Rechnung die gewünschten Werte.

Gemäß der Erfindung wird die Messung von elektrischen Strömen in n Leitern mit n-1 magnetoresistiven Sensoren durchgeführt (n ≥ 2). Hierdurch wird zum einen erreicht, daß, im Gegensatz zu der Messung mit Hall-Wandlern, auf Flußkonzentratoren verzichtet werden kann, da die Magnetfeldempfindlichkeit der magnetoresistiven Technologie etwa um den Faktor 20 über der des Hall-Effektes liegt. Darüber hinaus weisen die magnetoresistiven Sensoren gegenüber den auf dem Hall-Effekt basierenden Stromsensoren einen sehr kompakten Aufbau auf. Dieses beruht zum einen auf der Tatsache, daß aufgrund der physikalisch vorgegebenen Magnetfeldempfindlichkeit der Hall-Elemente in jedem Fall ein Eisenkern zur Flußführung und Feldkonzentration eingesetzt werden muß, der bei magnetoresistiven Sensoren entfällt. Darüber hinaus ist der Leiter zur Feldkompensation bei magnetoresistiven Sensoren als mikrosystemtechnische Lösung in den Sensorchip integriert, so daß auch hierdurch ein sehr kompakter Aufbau erreicht wird. Die auf magnetoresistiven Stromsensoren basierende Technologie benötigt darüber hinaus keinerlei Hilfsenergie auf dem hohen Meßpotential, wie sie zum Beispiel bei der potentialgetrennten Strommessung an Shunt-Widerständen erforderlich ist.

Gemäß der Erfindung ist es auch möglich, den erfindungsgemäßen Aufbau dahingehend zu verändern, daß Flußkonzentratoren verwendet werden. Der erfindungsgemäße kompakte Aufbau bleibt im Gegensatz zum Stand der Technik aber erhalten, da durch die Anordnung der Flußkonzentratoren die magnetoresistiven Sensoren dichter nebeneinanderliegend angeordnet werden können. Hierdurch wird erreicht, daß der durch die Verwendung der magnetoresistiven Sensoren erreichte kompakte Aufbau erhalten bleibt.

Die Messung von Strömen wird auch bei der magnetoresistiven Sensortechnologie auf die Messung der magnetischen Felder von stromdurchflossenen Leitern zurückgeführt.

Gemäß der Erfindung können elektrische Ströme in wenigstens zwei Leitern mit einem einfachen und kompakten Aufbau gemessen werden. Beispielsweise kann eine dreiphasige Strommessung an den Motorausgängen eines Wechselrichters durchgeführt werden, oder das erfindungsgemäße Verfahren findet seine Anwendung beispielsweise in leistungselektronischen Stellgliedern für elektrische Antriebe, wie zum Beispiel in Frequenzumrichtern oder in Servoreglern.

Dadurch, daß elektrische Ströme in n Leitern mit n-1 magnetoresistiven Sensoren gemessen und ermittelt werden, ist es in weiterer Ausgestaltung der Erfindung möglich, das erfindungsgemäße Verfahren auch für eine Fehlererkennung zu verwenden. Über die Bestimmung der Stromstärken der einzelnen Ströme ist es möglich, Überstrom und/oder Fehlerstrom zu detektieren und hierbei beispielsweise für antriebstechnische Anwendungen entsprechende Module zu schützen.

Darüber hinaus ist es möglich, aus der Strommessung andere Größen, wie zum Beispiel Spannungen und Leistungen abzuleiten.

Im Kurzschlußfall erfordert zum Beispiel ein sicheres Abschalten einer Endstufe kleinere Reaktionszeiten als zehn Mikrosekunden. Dieser Schutz kann mit einer Vorrichtung gemäß der Erfindung gewährleistet werden.

Ein Überlastschutz kann zum Beispiel über eine Überwachung der Integrale $\int i^2 \, dt$ beziehungsweise $\int i \, dt$ oder über einen Temperaturfühler erfolgen.

Geht man von einem im Stand der Technik üblichen Dreiphasenstrom aus, so sind zur Ermittlung der Stromstärken der drei Phasenströme erfindungsgemäß zwei magnetoresistive Sensoren notwendig.

Als Ausgangssignal liefern die magnetoresistiven Sensoren ein dem auszumessenden elektrischen Strom proportionales Signal. Je nach Richtung des Stromflusses in den Stromleitern messen die Sensoren Differenzen der Magnetfelder der Stromleiter, oder die Magnetfelder werden aufaddiert.

Wird eine Messung eines dreiphasigen Stromes durchgeführt, wobei die drei Phasenströme positive Stromrichtungen aufweisen, so messen die bei einer Messung eines Dreiphasenstromes vorgesehenen zwei magnetoresistiven Sensoren die Differenzen der Magnetfeldstärken von jeweils zwei der drei Stromleitern und geben direkt als Ausgangssignal jeweils eine Spannung, die der Differenz der jeweiligen Stromstärken der Phasenströme proportional ist. Durch Aufstellen der Gleichungen hierfür und der Regel, daß die Summe aller Stromstärken zu jedem Zeitpunkt gleich Null ist, können entsprechende Beziehungen hergestellt werden, so daß es möglich ist, mit zwei Sensoren Aufschluß über die drei Ströme zu erhalten.

Bei der erfindungsgemäßen Meßanordnung mit Flußkonzentratoren, bei der die Leiter durch Ferrit-Kerne geführt werden, treten folgende Vorteile auf:

- Entkoppelung von Feldstärke und -verlauf von der Leitergeometrie;
- vergrößerter Primärleiterquerschnitt, da die Flußkonzentration nicht mehr durch Verengen der Leiterbahnen vorgenommen wird; durch den vergrößerten Primärleiterquerschnitt ist die Verlustleistung geringer; hierdurch ist die Realisierung als SMD-Modul (Surface Mounted Device = oberflächenmontierbare Bauelemente) möglich;
- durch die magnetische Abschirmung durch den Ferrit-Kern entsteht weniger Wirbelstrom in einem gegebenenfalls als Schaltungsträger und/oder Kühlfläche dienenden und unter der Meßanordnung montierten Metallsubstrat, zum Beispiel einem im IMS- (Insulated Metal Substrate) oder DCB-Substrat (Direct Copper Bonding) oder in anderen benachbarten Metallteilen, wie Gehäuseelementen;
- Reduktion der elektromagnetischen Auswirkungen des Skinbeziehungsweise Proximity-Effektes;
- Abschirmung gegenüber äußeren magnetischen Störfeldern;
- kompaktere Bauweise möglich durch Flußkonzentration.

Der Aufbau der Meßanordnung mit Flußkonzentratoren benötigt nicht mehr Platz als der Aufbau ohne Flußkonzentratoren, obwohl die Flußkonzentratoren grundsätzlich etwas mehr Platz benötigen. Dieser Umstand ist darauf zurückzuführen, daß bei Verwendung von Flußkonzentratoren die Sensoren dichter beieinander angeordnet werden können und damit der Platzbedarf ungefähr gleich bleibt.

Weitere Einzelheiten der Erfindung können den Unteransprüchen entnommen werden.

Auf der Zeichnung ist ein Ausführungsbeispiel der Erfindung dargestellt, und zwar zeigen:

Fig. 1     ein erstes Ausführungsbeispiel;

Fig. 2    ein Diagramm der gemäß Fig. 1 auftretenden Feldstärke;

Fig. 3    ein zweites Ausführungsbeispiel;

Fig. 4    eine Sensorkennlinie;

Fig. 5    eine erfindungsgemäße Anordnung;

Fig. 6    eine erfindungsgemäße Anordnung mit Ferrit-Kern;

Fig. 7    ein geändertes Ausführungsbeispiel;

Fig. 8    eine Anordnung für eine Stromraumzeigerauswertung.

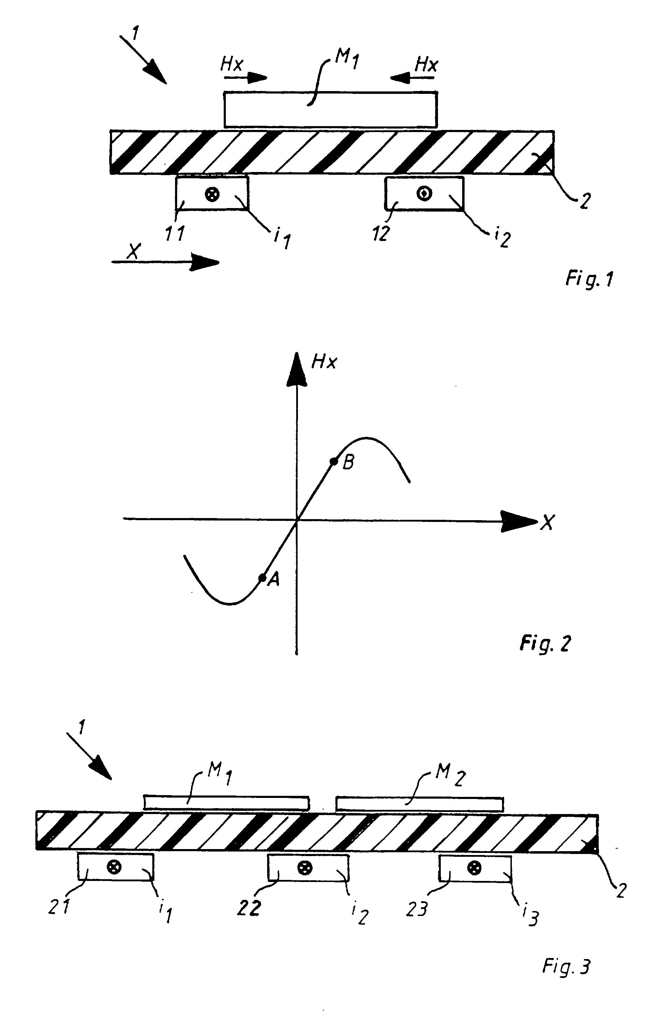

Fig. 1 zeigt eine Vorrichtung (1) mit einem Sensorchip ($M_1$), der auf einem Isolator (2) angeordnet ist.

Auf der dem Sensorchip ($M_1$) gegenüberliegenden Seite des Isolators (2) sind zwei elektrische Stromleiter (11, 12) angeordnet. In dem Stromleiter (11) fließt ein Strom der Stärke $i_1$, in dem Stromleiter (12) ein Strom der Stärke $i_2$. Die Richtung des Stromes in dem Stromleiter (11) weist in die Zeichenebene hinein, die Richtung des Stromes in dem Stromleiter (12) aus der Zeichenebene heraus.

Betrachtet man das von den Strömen hervorgerufene magnetische Feld in X-Richtung, so erhält man die in Fig. 2 dargestellte Kurve. Der magnetoresistive Sensor ($M_1$) ist als ein Feldgradienten messender Sensor ausgebildet, so daß mit dem Sensor die Differenz des magnetischen Feldes beispielsweise zwischen den Meßpunkten A und B gemessen wird.

Gemäß Fig. 3 sind drei Stromleiter (21, 22, 23) vorgesehen, in denen Ströme der Stärken $i_1$, $i_2$, $i_3$ fließen. Gemäß Fig. 3 fließen die Ströme in dieselbe Richtung, wobei es im vorliegenden Fall keine Rolle spielt, ob die Richtung in die Zeichenebene hinein- oder aus der Zeichenebene herausweist.

Die Sensoren ($M_1$ und $M_2$) messen die Differenzen der Magnetfeldstärken der Stromleiter (21, 22; 22, 23) und geben direkt als Ausgangssignal jeweils eine Spannung mit einem Wert, der zu der Differenz der jeweiligen Stromstärken $i_1$, $i_2$, $i_3$, proportional ist.

Man erhält damit folgende Beziehungen:

$$u_{M1} = K_1 (i_1 - i_2) \qquad\qquad (1)$$

$$u_{M2} = K_2(i_2 - i_3) \qquad\qquad (2)$$

K = Proportionalitätsfaktor.

Durch die Regel, daß die Summe der drei Stromstärken gleich Null ist, erhält man die dritte Gleichung:

$$\Sigma i_n = i_1 + i_2 + i_3 = 0 \qquad n = 1, 2, 3 \qquad\qquad (3)$$

Man hat nun drei Gleichungen für die drei Unbekannten $i_1$, $i_2$, $i_3$.

Bildet man die Differenz der an den Sensoren ($M_1$ und $M_2$) als Ausgangssignal erhaltenen Spannungen, erhält man:

$$u_{M1} - u_{M2} = K_1(i_1 - i_2) - K_2 (i_2 - i_3) \qquad\qquad (4)$$

Bildet man die Summe der an den Sensoren ($M_1$ und $M_2$) erhaltenen Spannungen, erhält man:

$$u_{M1} + u_{M2} = K_1(i_1 - i_2) + K_2 (i_2 - i_3) \qquad\qquad (5)$$

Aus Gleichung (3) folgt, daß

$$i_1 + i_3 = -i_2$$

ist. Bei einer Anordnung gemäß der Fig. 3 ist es durch entsprechende Kalibrierung möglich, dafür Sorge zu tragen, daß $K_1 = K_2 = K$ gilt. Damit folgt aus Gleichung (4) :

$$u_{M1} - u_{M2} = K(i_1 + i_3 - 2i_2) = K(-3i_2).$$

Durch entsprechende weitere Berechnungen erhält man die entsprechenden Werte für die Stromstärken $i_1$ und $i_3$, so daß man mit Hilfe der von den magnetoresistiven Sensoren ($M_1$, $M_2$) erhaltenen Spannungen Aufschluß über die in den Stromleitern (21, 22, 23) fließenden Ströme $i_1$, $i_2$, $i_3$ erhält.

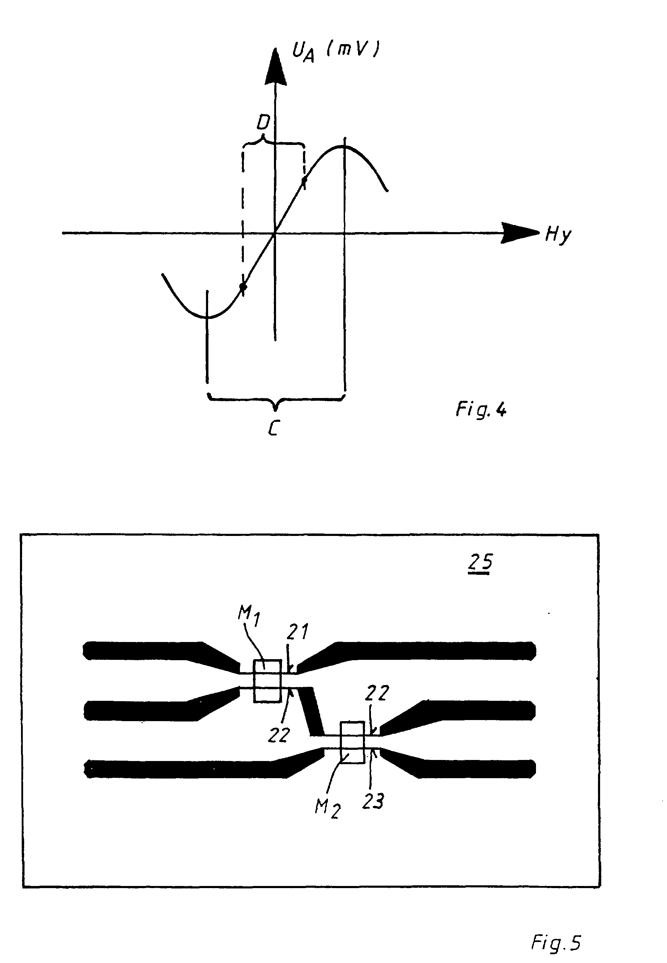

Vorzugsweise wird im annähernd linearen Bereich (D) der Kennlinie, die gemäß Fig. 4 für einen Sensorchip dargestellt ist, gemessen. Tritt ein Fehlerfall, zum Beispiel ein Kurzschluß, auf, so lassen sich die Messungen auch noch fehlerfrei durchführen, wenn man im Bereich (C) der Kennlinie gemäß Fig. 4 mißt.

Vorteilhaft werden die Einstellungen für die Messungen im annähernd linearen Kennlinienbereich mittels Kompensationsströmen eingestellt. Es ist aber auch möglich, die Messungen ohne Kompensationsströme durchzuführen.

Fließen die Ströme $i_1$, $i_2$, $i_3$, wie in Fig. 3 dargestellt, in gleicher Richtung, so werden die Differenzen der Stromstärken von den Sensoren ($M_1$, $M_2$) ermittelt.

Es ist aber auch möglich, beispielsweise den Stromleiter (22) derart anzuordnen, daß der Strom eine negative Stromrichtung aufweist, so daß nicht die Differenz der Magnetfeldstärken von den Sensoren ($M_1$, $M_2$) ermittelt wird, sondern in diesem Fall die Summe der Magnetfeldstärken. Das bedeutet, daß die Sensoren ($M_1$ und $M_2$) eine relativ große Feldstärke messen, was wiederum bedeutet, daß die Maximalwerte der Signale der Sensoren ($M_1$ und $M_2$) relativ hoch sind. Hierbei befinden sich die Sensoren in einem hohen Bereich der Kennlinie und können sich dem Grenzbereich der Kennlinie nähern oder diesen sogar überschreiten. Diese Ausführung ist auch aus einem weiteren Grund nicht sehr vorteilhaft, da es vorkommen kann, daß bei entgegengesetzter Flußrichtung der Ströme keine Magnetfelddifferenz auftritt, und in diesem Fall keine Meßwertermittlung möglich ist.

Gemäß der Erfindung ist es möglich, magnetoresistive Sensoren mit und ohne Kompensationsströmen zu verwenden. Wird ein Kompensationsstrom nicht vorgesehen, so ist das Ausgangssignal am Sensor kein lineares Abbild des zu messenden Stromes. Beispielsweise ist das Ausgangssignal in diesem Fall am Sensor bei sinusförmigen Strömen $i_1$, $i_2$, $i_3$ nicht sinusförmig ausgebildet, da sich der Arbeitspunkt in einem höheren Kennlinienbereich befindet. In diesem Fall ist es ebenfalls nachteilig, die Summe der Stromstärken zu erfassen, das heißt also, eine negative Stromrichtung eines Stromes zu wählen, da hierbei wieder die Gefahr besteht, aus dem ansteigenden Kennlinienbereich herauszukommen.

Das bedeutet, daß bei Stromfluß aller Ströme in gleicher Richtung besser auf einen Kompensationsstrom verzichtet werden kann.

Fig. 5 zeigt eine erfindungsgemäße Strommeßanordnung (25), welche Sensorchips ($M_1$, $M_2$) aufweist. Im Meßbereich des Sensorchips ($M_1$) sind die Stromleiter (21, 22) angeordnet. Im Meßbereich des Sensorchips ($M_2$) sind die Stromleiter (22, 23) angeordnet.

Der Stromleiter (23) ist zum Meßbereich des Sensorchips ($M_1$) mit einem großen Abstand angeordnet. Ebenso ist der Stromleiter (21) mit einem großen Abstand zu dem Meßbereich des Sensorchips ($M_2$) angeordnet, um Störfeldeinflüsse zu vermeiden oder zu verringern.

Durch die Ermittlung der Stromstärken $i_1$, $i_2$, $i_3$ ist es möglich, einen Kurzschluß oder einen Erdschluß festzustellen und innerhalb sehr kleiner Reaktionszeiten darauf zu reagieren, um ein sicheres Abschalten beispielsweise einer Endstufe zu gewährleisten.

Bei einem Kurzschluß wird ungewollt beispielsweise zwischen den Stromleitern (21 und 22) eine Verbindung hergestellt, so daß der Sensorchip ($M_1$) im wesentlichen den betragsmäßig stark anwachsenden Kurzschlußstrom in den beiden Stromleitern mißt.

Bei einem Erdschluß wächst der Strom ebenfalls sehr schnell an. Dieser Strom wird von einem der Sensorchips ($M_1$ oder $M_2$), je nachdem, wo der Erdschluß liegt, gemessen. Zur Sicherung der Leistungsstufe und der nachfolgenden Geräte, beispielsweise eines Motors, wird für die Phasenströme eine maximale Amplitude festgelegt. Diese maximale Grenze wird in einem Komparator mit dem Wert aus dem Sensor verglichen und somit ein Schutz der Endstufe gewährleistet.

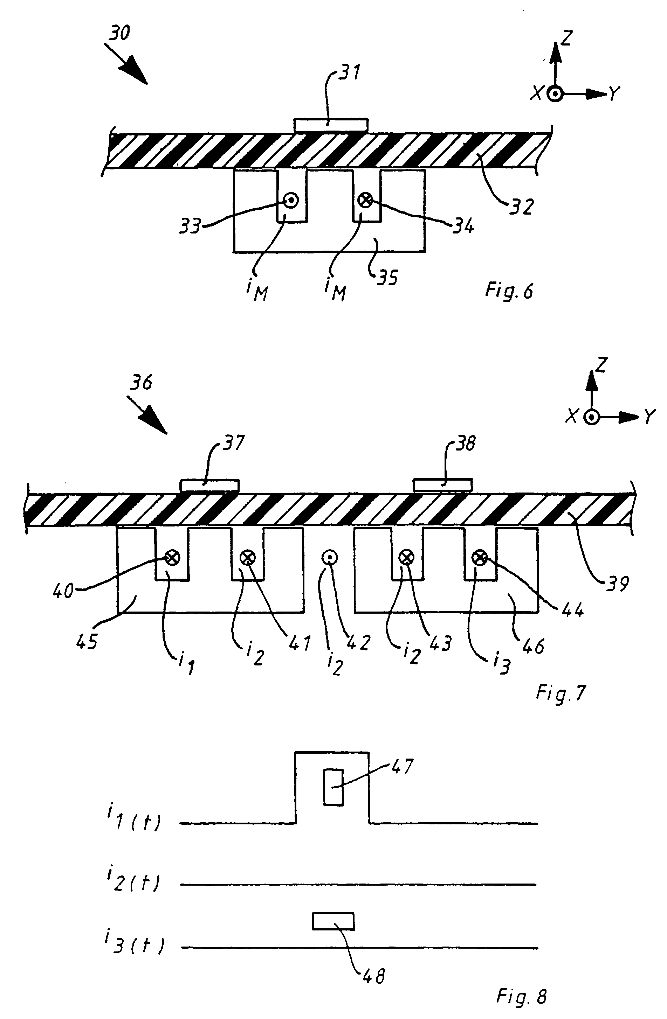

Fig. 6 zeigt eine Vorrichtung (30) mit einem Sensorchip (31), der auf einem Isolator (32) angeordnet ist.

Auf der dem Sensorchip (31) gegenüberliegenden Seite des Isolators (32) sind zwei elektrische Stromleiter (33, 34) angeordnet. Die Stromleiter (33, 34) sind innerhalb eines Ferrit-Kernes (35), welcher im Querschnitt im wesentlichen E-förmig ausgebildet ist, angeordnet. Jeder Stromleiter (33, 34) ist in einem Luftkanal des Ferrit-Kernes (35) zwischen den Schenkeln des Ferrit-Kernes mit Abstand zu diesen angeordnet.

Gemäß Fig. 7 ist ein weiterer Aufbau einer Vorrichtung (36) gezeigt. Die Vorrichtung (36) weist zwei Sensorchips (37, 38) auf, welche auf einem Isolator (39) angeordnet sind.

Auf der den Sensorchips (37, 38) gegenüberliegenden Seite des Isolators (39) sind elektrische Stromleiter (40, 41, 42, 43, 44) angeordnet.

Durch den Stromleiter (40) fließt ein Strom $i_1$, durch den Stromleiter (41) ein Strom $i_2$. Die Richtung des Stromes in den Stromleitern (41, 42) weist in die Zeichenebene hinein, ebenso die Richtung der Ströme $i_2$ und $i_3$ der Stromleiter (43, 44). Die Richtung des Stromes in dem Stromleiter (42) kommt aus der Zeichenebene heraus. Der Stromleiter (42) führt einen Strom der Stärke $i_2$.

Der Sensorchip (37) befindet sich in dem magnetischen Feld, welches von den in den Leitern (41, 42) fließenden Strömen $i_1$ und $i_2$ hervorgerufen wird. Der Sensorchip (38) befindet sich im magnetischen Feld, welches von den Strömen $i_2$ und $i_3$ der Stromleiter (43, 44) hervorgerufen wird.

Die Sensorchips (37, 38) befinden sich, anders als in Fig. 5 dargestellt, auf einer Höhe, das heißt nebeneinanderliegend. Dieses ist möglich, da die Stromleiter (40, 41) in einem im Querschnitt im wesentlichen E-förmig ausgebildeten Bauteil (45) aus Ferrit angeordnet sind, Ebenso sind die Stromleiter (43, 44) in einem Ferrit-Bauteil (46) angeordnet, welches im Querschnitt im wesentlichen E-förmig ausgebildet ist.

Durch die in den Fig. 6 und 7 gezeigte Meßanordnung mit Ferrit-Kernen (35, 45, 46) erhält man eine magnetische Abschirmung, so daß in benachbarten metallischen Gehäuseteilen und/oder Schaltungsträgern, wie zum Beispiel IMS-(Insulated Metal Substrate) und DCB-Substraten (Direct Copper Bonding) weniger Wirbelströme auftreten.

Weiterer Vorteil dieser Anordnung ist die Abschirmung gegenüber äußeren magnetischen Störfeldern.

Ein kompakterer Aufbau ist gemäß Fig. 7 im Vergleich zu dem Aufbau gemäß Fig. 5 dadurch möglich, daß die Sensoren (37, 38) dank der magnetischen Abschirmungswirkung näher beieinanderliegen können und damit im Gegensatz zu dem Aufbau gemäß Fig. 5 nebeneinander angeordnet werden können.

Fig. 8 zeigt eine Meßanordnung für eine Stromraumzeigerauswertung.

Bei der Modellbildung von Drehfeldmaschinen für regelungstechnische Zwecke hat sich die Raumzeigerdarstellung durchgesetzt. Für den wichtigen Sonderfall der dreiphasigen Systeme wird bei dieser Betrachtungsweise die geometrische Verschiebung der drei Wicklungen um 120°/p (p = Polpaarzahl) ausgewertet und die elektrischen Größen, die an den drei Wicklungen wirksam sind, zu einer komplexen Raumzeigergröße zusammengefaßt.

In einem ständerfesten Koordinatensystem wird die reelle Achse üblicherweise so gelegt, daß sie mit der Wirkungsrichtung der Wicklung u übereinstimmt. Es ergibt sich dann:

$$\underline{I}_s(t) = \frac{2}{3}\,(i_a(t) + a\cdot i_b(t) + a^2 i_c(t))$$

mit

$$a = e^{t\frac{2\pi}{3}}$$

und

$$\underline{I}_s(t) = komplexe\ Zahl$$

beziehungsweise

$$\underline{I}_S(t) = \begin{pmatrix} \mathrm{Re}\{\underline{I}_S(t)\} \\ \mathrm{Im}\{\underline{I}_S(t)\} \end{pmatrix} = \frac{2}{3}\begin{pmatrix} 1 & -\dfrac{1}{2} & -\dfrac{1}{2} \\ 0 & \dfrac{1}{\sqrt{3}} & -\dfrac{1}{\sqrt{3}} \end{pmatrix} \cdot \begin{pmatrix} i_a(t) \\ i_b(t) \\ i_c(t) \end{pmatrix} = \begin{pmatrix} i_\alpha(t) \\ i_\beta(t) \end{pmatrix}$$

Da bei elektrischen Maschinen üblicherweise $\Sigma\,i_{a,b,c} = 0$ gilt, vereinfachen sich die Gleichungen für den Raumzeiger zu:

$$\underline{I}_S(t) = \frac{2}{3}\left( \begin{array}{c} I_a(t) \\ \dfrac{I_b(t)}{\sqrt{3}} - \dfrac{I_c(t)}{\sqrt{3}} \end{array} \right) \qquad (6).$$

Diese Transformation, die bei geregelten Antrieben in der Regel auf dem Mikrocontroller/Signalprozessor durchgeführt wird, kann mit der Strommessung durchgeführt werden, wenn die Meßanordnung geeignet aufgebaut wird. Der Mikrocontroller wird hierdurch entlastet.

Gemäß Fig. 8 bestimmt der $\alpha$-Sensor (47) eine Größe, die proportional zu $i_\alpha(t)$ ist und entsprechend der $\beta$-Sensor (48) eine Größe, die proportional zu $(i_2(t) - i_3(t))$ ist. Die Normierung gemäß Gleichung 6 kann bei der analogen Aufbereitung der Signale berücksichtigt werden.

Durch die Anordnung gemäß Fig. 8 stehen die Meßrichtungen der Sensoren (47, 48) orthogonal aufeinander. Eine gegenseitige Beeinflussung wird dadurch minimiert.

Bezugszahlen

| | |
|---|---|
| 1 | Vorrichtung |
| 2 | Isolator |
| 11 | Stromleiter |
| 12 | Stromleiter |
| 21 | Stromleiter |
| 22 | Stromleiter |
| 23 | Stromleiter |
| 25 | Strommeßanordnung |
| 30 | Vorrichtung |
| 31 | Sensorchip |
| 32 | Isolator |
| 33, 34 | Stromleiter |
| 35 | Ferrit-Kern |
| 36 | Vorrichtung |
| 37, 38 | Sensorchips |
| 39 | Isolator |
| 40, 41, 42, 43, 44 | Stromleiter |
| 45 | Ferrit-Kern |
| 46 | Ferrit-Kern |
| 47 | $\alpha$-Sensor |
| 48 | $\beta$-Sensor |
| $M_1$, $M_2$ | Sensorchips |
| $I_1$, $I_2$, $I_3$ | Ströme |
| C, D | Kennlinienbereiche |
| $H_x$ | Magnetfeld |
| a | definierte Konstante |
| p | Polpaarzahl |
| u, v, w | Wicklungen einer dreiphasigen Drehstrom-Maschine |

**Patentansprüche**

1.  Verfahren zum Messen von elektrischen Strömen I in n Leitern mit $n \geq 2$ und n = ganze Zahl, wobei die Leiterströme die Randbedingung $\Sigma I = 0$ einhalten,
    **dadurch gekennzeichnet, daß** die Messung der Ströme in den n Leitern mit n-1 magnetoresistiven Sensoren ($M_1$, $M_2$, $M_3$ ... $M_{n-1}$) durchgeführt wird, wobei die Sensoren als Gradiometer zur Messung der von einem Leiterstrom oder mehreren Leiterströmen erzeugten magnetischen Feldstärkedifferenzen ausgebildet sind.

2. Verfahren nach Anspruch 1, **dadurch gekennzeichnet, daß** die Stromstärken ($i_n$) der Ströme in den n Leitern bestimmt werden.

3. Verfahren nach Anspruch 1, **dadurch gekennzeichnet, daß** die ermittelten Meßwerte zur Detektion von Überstrom und/oder Fehlerstrom verwendet werden.

4. Verfahren nach Anspruch 1, **dadurch gekennzeichnet, daß** die ermittelten Meßwerte zur Detektion von Spannungen und/oder Leistungen verwendet werden.

5. Verfahren nach Anspruch 1, **dadurch gekennzeichnet, daß** die von dem magnetoresistiven Sensor ($M_1$, $M_2$, $M_3$, ... $M_{n-1}$) erfaßten Leiterströme gleiche Flußrichtungen aufweisen.

6. Verfahren nach Anspruch 1, **dadurch gekennzeichnet, daß** wenigstens einer der von den magnetoresistiven Sensoren ($M_1$, $M_2$, $M_3$ ... $M_{n-1}$) erfaßten n Leiterströme eine den übrigen Leiterströmen entgegengesetzte Flußrichtung aufweist.

7. Verfahren nach Anspruch 1, **dadurch gekennzeichnet, daß** magnetoresistive Sensoren mit magnetischer Feldkompensation verwendet werden.

8. Verfahren nach Anspruch 1, **dadurch gekennzeichnet, daß** magnetoresistive Sensoren ohne magnetische Feldkompensation verwendet werden.

9. Verfahren nach Anspruch 1, **dadurch gekennzeichnet, daß** die Messung der n Leiterströme für regelungstechnische Aufgaben und/oder zur Fehlererkennung in leistungselektronischen Stellgliedern für elektrische Antriebe verwendet wird.

10. Verfahren nach Anspruch 1, **dadurch gekennzeichnet, daß** wenigstens zwei der n Leiter wenigstens teilweise mit Ferrit umgeben sind, wobei die Leiter gegen die Ferrit-Umhüllung (35, 45, 46) geeignet isoliert sind.

11. Verfahren nach Anspruch 1, **dadurch gekennzeichnet, daß** eine Stromraumzeigerauswertung durchgeführt wird, derart, daß in einem symmetrischen Dreiphasen-Stromsystem durch die Messung eines einzelnen Stromes mit einem Sensor (47) und durch die zusätzliche Bestimmung der Differenz der beiden übrigen Ströme mit einem weiteren Sensor (48), jeweils als Gradiometeranordnung ausgebildet, zwei Sensorausgangssignale generiert werden, welche die orthogonalen Stromraumzeiger dieses Systems repräsentieren.

12. Vorrichtung zur Durchführung des Verfahrens nach Anspruch 1, **dadurch gekennzeichnet, daß** die n Stromleiter (21, 22, 23) für die Leiterströme in der Nähe der n-1 magnetoresistiven Sensoren ($M_1$, $M_2$) angeordnet sind, wobei die Sensoren ($M_1$, $M_2$) so ausgelegt sind, daß sie die Differenz der von zwei Leiterströmen erzeugten magnetischen Feldstärken erfassen.

13. Vorrichtung nach Anspruch 12, **dadurch gekennzeichnet, daß** die Stromleiter derart angeordnet sind, daß zwei Stromleiter (21, 22) mit den zu messenden Leiterströmen in der Nähe des Meßbereiches eines Sensors ($M_1$) angeordnet sind, und daß die übrigen Stromleiter (23) mit Abstand zu diesem Meßbereich angeordnet sind.

14. Vorrichtung nach Anspruch 12, dadurch gekennzeich net, daß wenigstens einer der n Stromleiter (33, 34; 40, 41; 43, 44) wenigstens teilweise in einem Bauteil (35, 45, 46) aus Ferrit angeordnet ist, wobei das Bauteil (35, 45, 46) Schenkel aufweist, und daß der wenigstens eine der n Stromleiter (33, 34; 40, 41; 43, 44) mit einer hinreichenden Isolierung gegenüber dem Ferrit und/oder in einem hinreichenden Abstand zu den Schenkeln des Ferrit-Kerns angeordnet ist.

15. Vorrichtung nach Anspruch 14, **dadurch gekennzeichnet, daß** das wenigstens eine Ferrit-Bauteil (35, 45, 46) jeweils im Bereich der n-1 magnetoresistiven Sensoren ($M_1$, $M_2$) vorgesehen ist.

16. Vorrichtung nach Anspruch 14, **dadurch gekennzeichnet, daß** das Ferrit-Bauteil (35, 45, 46) im Querschnitt im wesentlichen E-förmig ausgebildet ist, und daß die Schenkel wenigstens teilweise an dem Isolator (2, 32, 39) angeordnet sind.

**17.** Vorrichtung nach Anspruch 16, **dadurch gekennzeichnet, daß** die Stromleiter (33, 34; 40, 41; 43, 44) zwischen den Schenkeln des Ferrit-Bauteiles (35, 45, 46) und mit einer hinreichenden Isolierung gegenüber dem Ferrit und/ oder in einem hinreichenden Abstand zu den Schenkeln des Ferrit-Kerns angeordnet sind.

**18.** Vorrichtung zur Durchführung des Verfahrens nach Anspruch 11, **dadurch gekennzeichnet, daß** die Meßrichtungen der beiden Sensoren (47, 48) orthogonal zueinander stehen, derart, daß eine gegenseitige Beeinflussung der Magnetfeldgradienten minimiert wird.

**Claims**

**1.** A method of measuring electric currents I in n conductors where $n \geq 2$ and n = a whole number, wherein the conductor currents observe the boundary condition $\Sigma I = 0$, **characterised in that** the currents in the n conductors are measured by n-1 magnetoresistive sensors ($M_1, M_2, M_3 ... M_{n-1}$), the sensors being formed as gradiometers for measuring the magnetic field intensity differences generated by a conductor current or a plurality of conductor currents.

**2.** A method according to claim 1, **characterised in that** the current intensities ($i_n$) of the currents in the n conductors are determined.

**3.** A method according to claim 1, **characterised in that** the measurements taken are used for detecting overcurrent and/or fault current.

**4.** A method according to claim 1, **characterised in that** the measurements taken are used for detecting voltages and/or outputs.

**5.** A method according to claim 1, **characterised in that** the conductor currents detected by the magnetoresistive sensor ($M_1, M_2, M_3 ... M_{n-1}$) have the same flow directions.

**6.** A method according to claim 1, **characterised in that** at least one of the n conductor currents detected by the magnetoresistive sensors ($M_1, M_2, M_3 ... M_{n-1}$) has a flow direction opposed to the other conductor currents.

**7.** A method according to claim 1, **characterised in that** magnetoresistive sensors with magnetic field compensation are used.

**8.** A method according to claim 1, **characterised in that** magnetoresistive sensors without magnetic field compensation are used.

**9.** A method according to claim 1, **characterised in that** the measurement of the n conductor currents is used for control engineering functions and/or for error detection in power-electronic actuators for electric drives.

**10.** A method according to claim 1, **characterised in that** at least two of the n conductors are at least partly surrounded by ferrite, the conductors being suitably insulated from the ferrite covering (35, 45, 46).

**11.** A method according to claim 1, **characterised in that** current-space vector evaluation is carried out in such a way that, in a symmetrical three-phase current system, by measuring an individual current with a sensor (47) and by additionally determining the difference between the two remaining currents with a further sensor (48), each formed as a gradiometer arrangement, two sensor output signals are generated which represent the orthogonal current-space vector of this system.

**12.** A device for carrying out the method according to claim 1, **characterised in that** the n current conductors (21, 22, 23) for the conductor currents are arranged in the vicinity of the n-1 magnetoresistive sensors ($M_1, M_2$), the sensors ($M_1, M_2$) being designed to detect the difference in the magnetic field intensities generated by two conductor currents.

**13.** A device according to claim 12, **characterised in that** the current conductors are arranged so that two current conductors (21, 22) with the conductor currents to be measured are arranged in the vicinity of the measuring range of a sensor ($M_1$), and **in that** the remaining current conductors (23) are arranged at a distance from this measuring range.

**14.** A device according to claim 12, **characterised in that** at least one of the n current conductors (33, 34; 40, 41; 43, 44) is at least partly arranged in a component (35, 45, 46) comprising ferrite, the component (35, 45, 46) having arms, and **in that** the at least one of the n conductors (33, 34; 40, 41; 43, 44) is adequately insulated from the ferrite and/or arranged at an adequate distance from the arms of the ferrite core.

**15.** A device according to claim 14, **characterised in that** the at least one ferrite component (35, 45, 46) is provided in the region of the n-1 magnetoresistive sensors ($M_1$, $M_2$).

**16.** A device according to claim 14, **characterised in that** the ferrite component (35, 45, 46) is substantially E-shaped in cross-section and **in that** the arms are arranged at least in part on the insulator (2, 32, 39).

**17.** A device according to claim 16, **characterised in that** the current conductors (33, 34; 40, 41; 43, 44) are arranged between the arms of the ferrite component (35, 45, 46) and are adequately insulated from the ferrite and/or are arranged at an adequate distance from the arms of the ferrite core.

**18.** A device for carrying out the method according to claim 11, **characterised in that** the measuring directions of the two sensors (47, 48) are orthogonal to one another so that mutual influencing of the magnetic field gradients is minimised.

**Revendications**

**1.** Procédé pour mesurer des courants électriques I dans n conducteurs avec $n \geq 2$ et n = nombre entier, les courants de conducteurs respectant la condition aux limites $\Sigma I = 0$; **caractérisé en ce que** la mesure des courants dans les n conducteurs est effectuée avec n-1 capteurs magnétorésistifs ($M_1$, $M_2$, $M_3$ ... $M_{n-1}$), les capteurs étant conçus comme des gradiomètres pour la mesure des différences d'intensité de champ magnétique qui sont générées. par un courant de conducteur ou plusieurs courants de conducteurs.

**2.** Procédé selon la revendication 1, **caractérisé en ce que** les intensités de courant ($i_n$) des courants sont calculées dans les n conducteurs.

**3.** Procédé selon la revendication 1, **caractérisé en ce que** les valeurs mesurées calculées sont utilisées pour la détection de courant de surcharge et/de courant de défaut.

**4.** Procédé selon la revendication 1, **caractérisé en ce que** les valeurs mesurées calculées sont utilisées pour la détection de tensions et/ou de puissances.

**5.** Procédé selon la revendication 1, **caractérisé en ce que** les courants de conducteurs enregistrés par le capteur magnétorésistif ($M_1$, $M_2$, $M_3$, ... $M_{n+1}$) présentent des sens de conduction identiques.

**6.** Procédé selon la revendication 1, **caractérisé en ce qu'**au moins l'un des n courants de conducteurs enregistrés par les capteurs magnétorésistifs ($M_1$, $M_2$,$M_3$, ... $M_{n+1}$) présentent un sens de conduction opposé aux autres courants de conducteurs.

**7.** Procédé selon la revendication 1, **caractérisé en ce qu'**on utilise des capteurs magnétorésistifs avec compensation de champ magnétique.

**8.** Procédé selon la revendication 1, **caractérisé en ce qu'**on utilise des capteurs magnétorésistifs sans compensation de champ magnétique.

**9.** Procédé selon la revendication 1, **caractérisé en ce que** la mesure des n courants de conducteur est utilisée pou des tâches techniques de réglage et de régulation et/ou pour la détection de défauts dans des actionneurs d'électronique de puissance pour des entraînements électriques.

**10.** Procédé selon la revendication 1, **caractérisé en ce qu'**au moins deux des n conducteurs sont entourés au moins partiellement de ferrite, les conducteurs étant isolés de façon appropriée par rapport à l'enveloppe de ferrite (35, 45, 46).

**11.** Procédé selon la revendication 1, **caractérisé en ce qu'**une analyse de l'indicateur de l'espace de courant est effectuée de telle façon que, dans un système de courant symétrique à trois phases, la mesure d'un seul courant avec un capteur (47) et le calcul supplémentaire de la différence des deux autres courants avec un autre capteur (48), conçu respectivement comme un agencement de gradiomètre, entraînent la génération de deux signaux de sortie de capteur qui représentent les indicateurs d'espace de courant orthogonaux de ce système.

**12.** Dispositif pour l'application du procédé selon la revendication 1, **caractérisé en ce que** les n conducteurs de courant (21, 22,23) pour les conducteurs de courant sont disposés à proximité des n-1 capteurs magnétorésistifs ($M_1$, $M_2$), les capteurs ($M_1$, $M_2$) étant dimensionnés de telle façon qu'ils enregistrent la différence entre les intensités de champ magnétique générées par deux courants de conducteurs.

**13.** Dispositif selon la revendication 12, **caractérisé en ce que** les conducteurs de courant sont disposés de telle façon que deux conducteurs de courant (21, 22) avec les courants de conducteurs à mesurer sont disposés à proximité de la plage de mesure d'un capteur ($M_1$), et **en ce que** les autres conducteurs de courant (23) sont disposés à distance d cette plage de mesure.

**14.** Dispositif selon la revendication 12, **caractérisé en ce qu'**au moins l'un des n conducteurs de courant (33, 34 ; 40, 41 ; 43, 44) est disposé au moins partiellement dans un composant (35, 45, 46) en ferrite, le composant (35, 45, 46) présentant des branches, et **en ce qu'**au moins l'un des n conducteurs de courant (33, 34 ; 40, 41 ; 43, 44) est disposé avec une isolation suffisante par rapport au ferrite et/ou à une distance suffisante par rapport aux branches du noyau de ferrite.

**15.** Dispositif selon la revendication 14, **caractérisé en ce qu'**au moins un composant en ferrite (35, 45, 46) est prévu respectivement dans la zone des n-1 capteurs magnétorésistifs ($M_1$, $M_2$).

**16.** Dispositif selon la revendication 14, **caractérisé en ce que** le composant en ferrite (35, 45, 46) est conçu en section sensiblement en forme de E et **en ce que** les branches sont disposées au moins partiellement sur l'isolateur (2, 32, 39).

**17.** Dispositif selon la revendication 16, **caractérisé en ce que** les conducteurs de courant (33, 34 ; 40, 41 ; 43, 44) sont disposés entre les branches du composant en ferrite (35, 45, 46) et avec une isolation suffisante par rapport au ferrite et/ou à une distance suffisante par rapport aux branches du noyau en ferrite.

**18.** Dispositif pour appliquer le procédé selon la revendication 11, **caractérisé en ce que** les directions de mesure des deux capteurs (47, 48) sont orthogonales l'une par rapport à l'autre de telle sorte qu'on minimise une influence réciproque des gradients de champ magnétique.

*Fig. 1*

*Fig. 2*

*Fig. 3*

Fig. 4

Fig. 5

Fig. 6

Fig. 7

Fig. 8